Europäisches Patentamt

European Patent Office

Office européen des brevets

(11) Publication number : **0 313 580 B1**

(12) **EUROPEAN PATENT SPECIFICATION**

(45) Date of publication of patent specification :
03.06.92 Bulletin 92/23

(51) Int. Cl.⁵ : **B05D 3/06**

(21) Application number : **87905034.2**

(22) Date of filing : **01.07.87**

(86) International application number :
**PCT/US87/01597**

(87) International publication number :
**WO 88/00097 14.01.88 Gazette 88/02**

(54) **RADIATION CURABLE TEMPORARY SOLDER MASK.**

(30) Priority : **02.07.86 US 881872**

(43) Date of publication of application :
**03.05.89 Bulletin 89/18**

(45) Publication of the grant of the patent :
**03.06.92 Bulletin 92/23**

(84) Designated Contracting States :
**DE FR GB IT**

(56) References cited :
EP-A- 0 015 004
EP-A- 0 121 391
EP-A- 4 058 443
DE-A- 1 447 673
US-A- 2 476 937
US-A- 3 139 352
US-A- 3 853 576
US-A- 3 853 578
US-A- 4 064 287
US-A- 4 120 843
US-A- 4 246 147
US-A- 4 254 163
US-A- 4 351 880

(56) References cited :
US-A- 4 357 413
US-A- 4 410 562
US-A- 4 438 227
US-A- 4 514 713
PHOTOGRAPHIC SCIENCE AND ENGINEER-
ING, vol. 11, no. 2, March/April 1967, pages
93-96; R.W. WOODRUFF et al.: "Image for-
mationby photoadhesion"

(73) Proprietor : **LOCTITE CORPORATION**
**705 North Mountain Road**
**Newington, Connecticut 06111 (US)**

(72) Inventor : **DRAIN, Kieran, F.**
**167 Johnson Avenue**
**Meridan, CT 06450 (US)**
Inventor : **NATIVI, Larry, A.**
**245 Annes Court**
**Rockey Hill, CT 06067 (US)**
Inventor : **SUMMERS, Robert**
**220 Newfield Street§Apartment No. 402**
**Middletown, CT 04657 (US)**

(74) Representative : **Marchant, James Ian et al**
**Elkington and Fife Prospect House 8**
**Pembroke Road**
**Sevenoaks, Kent TN13 1XR (GB)**

## Description

### Field of the Invention

This invention relates to a method of providing temporary masking on electrical/electronic components and to compositions utilized in said method. Such compositions are photopolymerizable producing coatings with limited adhesive properties such that they provide a measure of adhesion sufficient to withstand component processing but insufficient to prevent easy mechanical removal of the coating. Typical applications include, but are not limited to, masking specific areas of printed circuit boards during soldering, plating or conformal coating operations.

### Background Art

Heretofore, methods of providing printed circuit board protection have been limited to tape products and evaporative coatings.

The tape products as exemplified by Temp-R-Tape M727 and M737 from CHR Industries, Inc., are used by cutting to size and manually applying the tapes to the board. As such, these products do not lend themselves to automation and require a high level of labor input. Removal of the tapes is most often by peeling, although several water or solvent soluble versions are available on the market.

Evaporative products are typified by the masks available from Chemtronics, Inc., e.g., Chemask W, Chemask S, and Chemask Peelable. Such products are latex based and are applied to circuit boards as low viscosity liquids. Following board processing, the mask is removed from the board by peeling or washing in water or freon depending upon the grade. While it is possible to automatically apply such products to circuit boards, the long drying time required before a board can be further processed prohibits their use in high speed non-labor intensive production situations.

While photopolymerizable temporary masks are known in the electronics industry, their use has been as process aids in the development of permanent resists and polymer inner layers. It has never before been proposed to utilize a liquid photopolymerizable resist which can be mechanically stripped after photopolymerization.

### SUMMARY OF THE INVENTION

Accordingly, it is an aspect of the present invention to provide a composition and method for providing temporary masking of electrical or electronic components compatible with a high speed production operation. The composition is a radiation curable viscous liquid composition which provides minimal adhesion properties and substantial cohesive properties so that when cured, it can be readily removed in the manner of an adhesive tape.

The present invention provides a temporary mask composition for use in operations for manufacturing electrical or electronic parts, the composition comprising:

(a) a radiation curable monomer formulation including a predominant amount of acrylicend capped prepolymer,

(b) a radical photoinitiator, characterized in that the composition also comprises

(c) an adhesion reducing component selected from polymeric plasticizers and acrylicesters of saturated fatty alcohols, vinyl esters of saturated fatty acids, monoacrylic esters of polyalkylene oxides, or mixtures thereof, in an amount sufficient to reduce the tensile shear adhesion of the composition when cured to the electronic or electrical part to about 379.2 kPa (55 psi) or less, the composition having sufficient cohesive strength to permit the cured composition to be peeled from the substrate mechanically or by hand in substantially one piece.

In particular, the radiation curable composition is characterized by cured properties a) of positive adhesion to the substrate to which the composition is applied, but insufficient adhesion to resist peeling forces applied by hand; and b) of sufficient cohesive strength to allow substantially all of the cured composition to be stripped mechanically or by hand in a single piece. Suitably the adhesion of the cured composition to the substrate as measured in the tensile shear mode, is between about 34.5 and 379.2 kPa (5 and 55 psi). This level of adhesion is sufficient to prevent ingress of solvent solder, plating or coating materials but low enough to allow easy dry stripping mechanically or by hand.

In general, the process for providing temporary protection comprises applying the compositions of the invention to the areas to be masked. Exposing such areas to actinic radiation to produce a dry coating which is resistant to debonding during soldering, plating, or cleaning operations but which can be readily peeled from the substrate after all necessary processing has been completed.

An aspect of the invention is a method for providing a conformally coated circuit board having at least one discreet uncoated conductive connector area, the method comprising providing a uncoated circuit board having said conductor area, applying a temporary mask formulation as described above to said connector area, overcoating the entire board, including the masked connector areas, with a UV curable conformal coating composition, irradiating the board to cure the conformal coating and temporary mask and stripping the mask mechanically or by hand from said connector area.

A further aspect of the invention comprises a method of temporarily masking a portion of a electronic component (such as a circuit board or a component on a circuit board) which is to be subjected to subsequent processing operations, such as plating, soldering, and cleaning operations the method comprising applying a mask composition as previously described to said portion of said electronic component, irradiating to cure the mask composition, performing the said subsequent processing operation and then stripping the cured mask mechanically or by hand from said portion of said electronic component.

It should be understood that the mechanical or hand peeling step is a dry stripping step, that is, neither solvents, solvent vapors nor developer solutions are needed to accomplish the stripping of the cured mask.

## BRIEF DESCRIPTION OF THE DRAWINGS

Figure 1 is a top plan view of a conformally coated electronic printed circuit board having conductive tabs overcoated with both the temporary mask formulation and the conformal coating.

Figures 2-5 show a side sectional view of the board as taken along line 2-2 of Figure 1 as the board is moved in a clamping machine which removes the cured temporary mask and overlying coating from the connector tabs of the board to expose the underlying conductive surfaces.

## DETAILED DESCRIPTION OF THE INVENTION

The method of the invention is described above.

The compositions utilizable in the invention can be formulated in a number of ways, including using monomers such as vinyl stearate in radiation curable formulations to reduce the adhesion normally obtained and using high levels of plasticizer or filler for the same purpose. Examples of radiation curable formulations include those based on acrylic monomers; unsaturated polyesters; thiol-ene formulations, and formulations based on other vinyl monomers such as N-vinyl pyrrolidone; N-vinyl carbazole; vinyl acetate; styrene; etc. Most suitably, the radiation curable formulations contain a predominant amount of an acrylic capped prepolymer such as an acrylated or methacrylated polyester urethane; an acrylate or methacrylate capped polybutadiene urethane; an acrylate or methacrylate ester prepared by reaction of (meth)acrylic acid with a polyepoxide resin; a (meth)acrylate terminated butadiene polymer such as Hycar® VTB or VTBN; or an acrylate or methacrylate capped silicone.

Unlike the prior use of radiation cured resist materials in electronics assembly operations, the invention herein requires that the composition only produce minimal adhesion, sufficient to resist ingress by solder, coating or plating materials during application and processing operations, but insufficient to resist hand peeling. By formulating compositions to these specifications, the applicants herein have discovered that substantial improvements in automating the assembly of electronic parts can be obtained. In particular, the formulations can be dispensed and cured with a few minutes in an automated process, eliminating the need for hand application of tapes or long dry times for latex formulations. The cost advantages in automating this operation are sufficient to overcome the substantially higher cost of the monomer formulations themselves over tapes or latexes.

The preferred formulations of the invention also have sufficient cured cohesive strength for substantially all of the cured material to be peeled off in one piece. Additionally, they are preferably curable within 5 seconds on exposure of 365 nm UV light of an intensity of at least 20,000 $\mu$ W/cm$^2$.

Although adhesion must be low, the cured product must be able to standup to highly stressful environments including:

(1) Wave soldering, or vapor phase soldering i.e. immersion in molten solder 273,9°C (525°F) 10-30 seconds, or exposure to Fluorinert™ vapor 218,33°C (425°F) 10-30 seconds. This property is relevant to non-conformal coating related circuit board masking.

(2) Solvent cleaning with solvents such as Freon™ TMS or Fluorinert™. This property is relevant to component masking.

(3) High temperature exposure, e.g. 148,9°C (300°F) for 30 minutes. This property is relevant to where the transformer is coated with a heat curing varnish.

Several strategies can be used to formulate a temporary mask composition of the invention with the requisite low adhesion and relatively high cohesive strengths. Typically a conventional acrylic based UV curable composition which produces a flexible tough film will be modified by addition of one or more co-monomers which have very poor adhesive properties. Vinyl esters of saturated oil acids, such as vinyl stearate or vinyl palmitate, and acrylicesters of saturated hydrocarbons ($C_{10}$ or greater) or of poly(alkylene oxide)s having three or more alkoxy repeat units, such as ethoxyethoxyethyl acrylate, will be employed to reduce adhesion of the composition. Plasticizers which will not leave a residue on the substrate circuit board when the cured mask is stripped off may also (or alternatively) be incorporated into the formulation to reduce adhesion. Suitably, polymeric plasticizers may be employed as non-migratory plasticizers. As a still further alternative, adhesion may be reduced by loading the composition heavily with filler, such as a fumed silica, to reduce substrate wetting by the composition. This latter alternative, however, is the least preferred as wetting is likely to be highly variable and poor wetting can lead to poor mask performance, permitting ingress of solder, coatings or other subsequent processing materials.

Compositions of the invention are typically highly viscous materials. Suitably they are gel-like materials having viscosities in excess of 100 000 MPas (100,000 cps), preferably about 300 000 - 400 000 MPas 300,000-400,000 cps). This high viscosity is in part due to the necessity of using high levels of monomers which are themselves polymers capped with acrylic or vinyl groups in order to produce a formulation having sufficient cohesive strength to be readily peeled from the board surface. Preferably such monomers represent the highest percentage by weight component in the formulation. However, the high viscosity of the formulation provides a processing advantage as well. In particular, it is possible to use the composition as a mask for conformal coating operations even before the mask composition has been cured. After application of the masked composition to the areas of the board to be protected from the conformal coating, the entire board is conformally coated in a spray or dip operation with a UV curable permanent coating formulation. The board is then placed in a UV oven where both the coating and the mask composition are simultaneously cured. The mask can then be peeled off mechanically or by hand, removing the portion of the conformal coating overlying the mask but leaving the coating over the rest of the board intact.

It may be desirable for application purposes to reduce the viscosity with a volatile solvent, for instance, so that the product can be sprayed. Evaporation of the solvent will return the product to its high viscosity, non-migrating character.

Preferred formulations comprise:

50-65% of a (meth)acrylated urethane, a (meth)acrylated polyester urethane, a (meth)acrylated polyepoxide, a (meth)acrylated polybutadiene or mixtures thereof;

10-30% of a monofunctional ethylenically unsaturated diluent monomer;

0-3% of a monomer having plural (meth)acrylic functionality;

0.5-5% of a monomer selected from vinyl esters of saturated oil acids,

0-20% of a poly(alkylene oxide) (meth)acrylate having three or more alkoxy repeat units or a saturated $C_{10}$ or higher hydrocarbyl (meth)acrylate, and 0-10% (preferably 2-6%) of a silica thixotrope.

The compositions may further comprise conventional amounts of stabilizers, fillers, non-reactive diluents, pigments and the like.

Suitable diluent monomers include monomers having single (meth)acrylate or vinyl groups such as tetrahydrofufural methacrylate, hydroxypropyl methacrylate, vinyl acetate, styrene, isobornyl acrylate, N-vinyl pyrrolidone, N-vinyl carbazole, etc. Preferably the diluent monomer is selected from the group consisting of isobornyl acrylate, N-vinyl pyrrolidone and N-vinyl carbazole as formulations using these monomers can be readily cured at lower intensity UV irradiation.

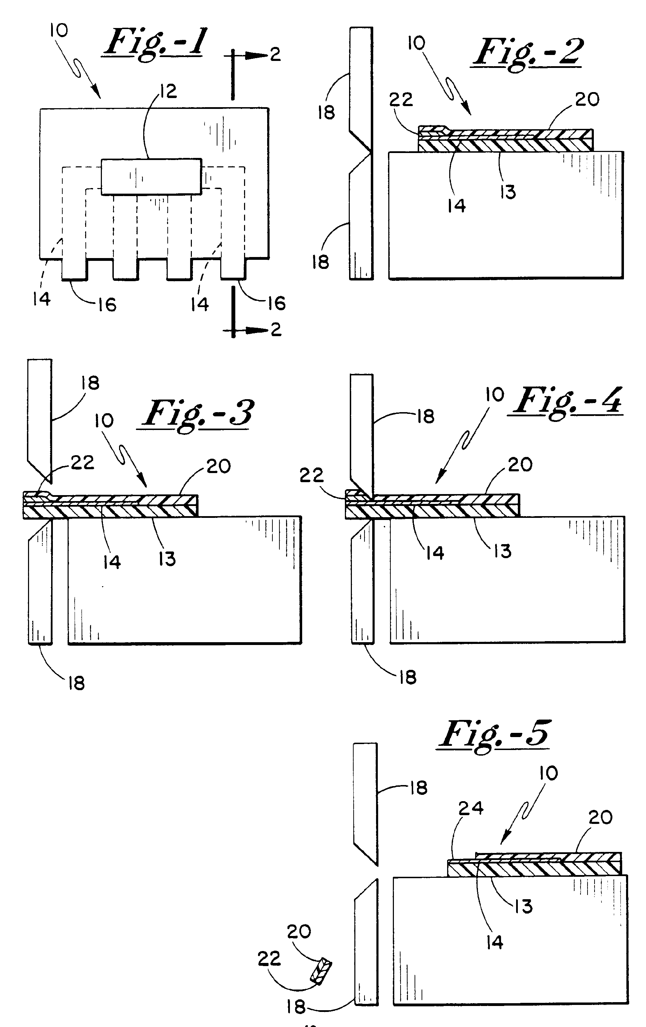

Referring now to the drawings there is shown in Figure 1 a printed circuit board 10 having a raised electronic component 12 from which extend a series of conductive pins, not shown. The pins are soldered to conductive pads, also not shown, on the board. The board is a laminate, as best shown in figures 2-5, of epoxy glass composite or other insulator which is overlaid with a conductive metal layer. The conductive layer has been etched in image wise manner to provide discrete conductive paths 14 from the individual pins of component 12 to individual connection tabs 16, thereby to provide connection means to the component.

In coating the board 10, there was first applied a layer of the temporary mask formulation of the invention to the connection tabs and then the entire board was coated with a conventional UV curable conformal coating. Most suitably the conformal coating is one which cures by both UV and a secondary moisture or oxidation mechanism such as described in U.S. 4,415,604, 4,424,252, and U.S. 4,551,523. The board was then irradiated to cure both the temporary mask and the conformal coating formulations. The conformal coating and cured mask are designated by the numerals 20 and 22, respectively in Figures 2-5.

After the coating and mask have been fully cured, the conductive surfaces of tab 16 may be easily exposed simply by pulling the coating and mask off in a single piece without the use of solvent. This operation may be done by hand but is more preferably done mechanically as shown in Figures 2-5. Figure 2 shows the coating board in sectional view in a machine for removing the mask and coating from the tab 16. The machine includes a pair of mechanical jaw 18, means not shown for opening and closing the jaws, and means, also not shown, for moving the board under and out from between the jaws. In operation Jaws 18 are opened and the tabs 16 of the board are slid under the jaws (Figure 3). The jaws are then closed onto the board (Figure 4) and the board pulled from between the jaws (Figure 5). The mask and the conformal coating overlying the mask are cleanly stripped from tabs 16 to expose the connection surfaces 25 without damaging the integrity of the conformal coating of the remaining portion of the board.

Other applications of the temporary mask are as a temporary sealant for protecting electronic components from subsequent soldering or vapor cleaning operations and as a mask for connector pins of a transformer assembly prior to unitizing the wire winding of the transformer with a lacquer or varnish formulation.

Vapor cleaning of circuit boards utilizes aggressive solvents, such as Freon™ TMS and Fluorinert™, which can damage some components soldered on the board, particularly unsealed components such as dip switches and adjustable potentiometers. Such components can be protected by temporarily sealing the component with a layer of cured temporary mask formulation (e.g. over dip switch lever members). Alternatively, in an improvement over a conventional procedure, preformed polyethylene caps may be bonded over the component using a temporary mask formulation of the invention in place of the conventionally used solvent based adhesives. The temporary mask will cure through polyethylene so the formulation can be fully cured both inside and outside the cap.

The invention will be better illustrated by reference to the following non-limiting examples, it being understood that a skilled person can readily formulate other radiation curable compositions useful in the inventive method with reference to his own formulation skill and the desired property parameters set forth herein.

EXAMPLE 1

The composition of Table I was applied to the connector fingers of a printed circuit board. The circuit board was then spray coated with a conformal coating (Loctite Product 361). Both materials were cured simultaneously by exposure to ultraviolet radiation, 365 nm 70,000 $\mu$W/cm$^2$, for 10 seconds. Subsequent to curing, the cured mask was readily removed by peeling, exposing an area of the board free from a conformal coating which would interfere with the electrical performance of the unit.

## TABLE I

| | % Wt. |
|---|---|
| Acrylated polyester urethane (Morton Thiokol Urithane 782) | 40.53 |
| Acrylated polyester urethane (Morton Thiokol Urithane 783) | 13.08 |
| N-vinyl pyrrolidone | 24.97 |
| Trimethylolpropane ethoxylate triacrylate | 2.00 |
| 1-Benzoyl cyclohexanol | 3.00 |
| Vinyl Stearate | 1.75 |
| Pigment red 57 | 0.01 |
| Silicon dioxide | 4.00 |
| Polyester plasticizer (Plasthall P670 CP Hall) | 10.00 |
| Metal Chelator (9% NA EDTA Soln) | 0.70 |

EXAMPLE 2

The composition of Table II was applied to a number of plated through holes on a circuit board which had been populated with a variety of insertion mounted devices. The board was irradiated for 5 seconds at 70,000 $\mu$W/cm$^2$, 365 nm, to fully cure the mask. The board was then run through the soldering process so fixing these components permanently on the board. Subsequent to this process, the cured mask was easily peeled off the board revealing no solder contamination of the masked areas.

## TABLE II

|  | % Wt. |
|---|---|
| Acrylated polyester urethane (Morton Thiokol Urithane 782) | 50.99 |
| Acrylated polyester urethane (Morton Thiokol Urithane 783) | 14.99 |
| N-vinyl pyrrolidone | 12.39 |
| Ethoxyethoxyethyl acrylate | 12.39 |
| 1-Benzoyl cyclohexanol | 2.83 |
| Vinyl stearate | 1.75 |
| Silicon dioxide | 4.00 |
| Pigment red 57 | 0.05 |
| Metal Chelator (9% Na EDTA Soln) | 0.66 |

EXAMPLE 3

The compositions of Table 1 was applied to steel hex button substrates. The buttons were overlaid with (i) glass plates =5,1 x 5,1 x 0,64 cm (2″ x 2″ x 0.24″) and (ii) with FR4 epoxy-glass fiber laminate plaques =7,6 x 7,6 x 0,4 cm (3″ x 3″ 0.15″). Irradiation through the top plate for (i) 10 seconds and (ii) 60 seconds, 365 nm 70,000 $\mu$W/cm$^2$ fully cures the mask composition. In all cases off-torque values recorded were less than =344,74 kPa (50 psi).

A value of $\leqq$ =379,2 kPa (55 psi) has been found to guarantee easy removal of the mask from circuit board connector fingers by automatic equipment operating in a tensile shear mode.

EXAMPLE 4

The composition of Table II was applied to the connector fingers of a printed circuit board. The circuit board was then conformally coated (with Loctite Product 361). Both materials were cured simultaneously by exposure to ultraviolet radiation, 365 nm 70,000 $\mu$W cm$^2$ for 10 seconds.

Subsequent to curing, the cured mask was removed in an automated assembly operation by inserting the edge connector between hydraulically operated steel jaws, and withdrawing the board against the action of the closed jaws. This process is better understood by reference to Figures 2-5.

This example illustrates that this new masking method allows this masking operation to be totally automated with automatic dispensing, curing and removal.

EXAMPLE 5

The test of Example 3 was repeated except that cure conditions for both the steel to glass and steel to FR4 epoxy-glass fiber laminate were 10 seconds. Two formulations were used, Loctite FMD 57, a circuit board conformal coating formulation of the type described in U.S. 4,551,523, and a composition as in Example 1. Table III gives the results of the test. The cured Loctite FMD 57 formulation cannot be peeled from a clean circuit board without use of solvents.

## Table III

### Adhesive Properties of Permanent vs. Temporary Peelable Mask
### ASTM No. D-3658

Cure Conditions    10 Sec. 100,000 $\mu$ Wcm$^{-2}$    365 nm

| Product | Steel hex button to glass | Steel hex button to FR4 epoxy glass |
|---|---|---|
| FDM 57 | 23,52 mkg$^{-1}$ (420 in lb$^{-1}$) | 4,76 mkg$^{-1}$ (85 in lb$^{-1}$) |
| Composition of Example 1 | 1,8 mkg$^{-1}$ (30 in lb$^{-1}$) | 0,78 mkg$^{-1}$ (14 in lb$^{-1}$) |

EXAMPLE 6

Polyethylene and Valox™, the conventional housing material for dip switches and the like, are very low energy plastics and satisfactory adhesion to these materials (i.e. in the 34,5 about 379.2 kPa (5-about 50 psi) range) may require a formulation which provides somewhat higher adhesion to other materials than those previously described. A suitable formulation which cured is resistant to aggressive solvents and can readily be pealed from circuit boards or Valox™ dip switch housings is shown in Table IV.

## Table IV

### Component Mask Composition

| Ingredient | % |
|---|---|
| Acrylate Urethane Resin (Interez CMD8850 - 20R) | 63.27 |
| Isobornyl acrylate | 15.77 |
| Ethoxyethoxyethyl acrylate (Morton Thiokol RC20) | 15.77 |
| 1-Benzoyl cyclohexanol | 2.83 |
| Vinyl stearate | 1.65 |
| Butyrated hydroxy toluene | 0.71 |
| | 100.00 |

Table V compares the adhesive properties of the Table IV composition and the composition described in Example 1. It can be seen that greater adhesion is necessary to provide sufficient bonding on difficult to bond plastics such as the Valox™ switch over that required to bond to gold plated connectors tin plated through holes. The adhesive properties are still less than that shown in Table III for the permanent conformal coating and allow easy mechanical removal from the board.

### Table V

**Adhesive Performance of Component and Circuit Board Masks. ASTM No. D 3658 Cure Conditions 10 Sec. 100,000 $\mu$ Wcm$^{-2}$ 365 nm**
==========================================

| Composition | Steel hex button to glass | Steel hex button to FR4 epoxy glass |
|---|---|---|
| Circuit Board Mask | | |
| Composition 1 Example 1 | 1,80 mkg$^{-1}$ (30 in lb$^{-1}$) | 0,78 mkg$^{-1}$ (14 in lb$^{-1}$) |
| Component Mask | | |
| Composition Table II | 8,06 mkg$^{-1}$ (144 in lb$^{-1}$) | 2,91 mkg$^{-1}$ (52 in lb$^{-1}$) |

Table VI illustrates the weight change of the cured composition of Table IV when exposed to Fluorinert immersion 90°C, for 8 minutes.

No significant weight change was observed indicating the suitability of the mask composition. Seal integrity is ensured (no Fluorinert™ absorption) and no uncured residue is left on the component to be masked (no significant weight loss indicative of extraction of uncured residue).

### Table VI

### Wt loss/gain on Fluorinert Exposure

| Initial Wt. | Wt. After exposure | Wt. Change | % Wt Change |
|---|---|---|---|
| 6.9568 gms | 6.9467 gms | -0.0101 | -0.145 |

### EXAMPLE 7

The composition of Table IV was applied to the top part of a DIP switch Model No. 765B08 from Grayhill Corp., Chicago, IL. The mask was cured by irradiation for 5 seconds at 100,500 $\mu$W cm$^{-2}$ 365 nm. After curing the integrity of the seal was tested by immersion in agitated Fluorinert™ (3M Co.) at 90°C for 8 minutes. Seal integrity was perfect as evidenced by the lack of air bubble emissions from the switch. The switch mask was then removed by manually peeling from the plastic housing. In practice the mask is not removed until the switch is inserted into a printed circuit board and wave soldered. The mask prevents solder flux and cleaning solvents from entering the inner compartment of the D.I.P. switch.

### Claims

1. A temporary mask composition for use in operations for manufacturing electrical or electronic parts, the composition comprising:

(a) a radiation curable monomer formulation including a predominant amount of acrylicend capped prepolymer,

(b) a radical photoinitiator, characterized in that the composition also comprises

(c) an adhesion reducing component selected from polymeric plasticizers and acrylicesters of saturated fatty alcohols, vinyl esters of saturated fatty acids, monoacrylic esters of polyalkylene oxides, or mixtures thereof, in an amount sufficient to reduce the tensile shear adhesion of the composition when cured to the electronic or electrical part to about 379.2 kPa (55 psi) or less, the composition having sufficient cohesive strength to permit the cured composition to be peeled from the substrate mechanically or by hand in substantially one piece.

2. A composition as claimed in claim 1 characterized in that the composition has a viscosity of at least about 100,000 mPas (100,000 cps).

3. A composition as claimed in claim 1 or 2 wherein the acrylate end capped prepolymer is an acrylated or methacrylated polyester urethane; an acrylate or methacrylate capped polybutadiene urethane; an acrylate or methacrylate ester prepared by reaction of (meth)acrylic acid with a polyepoxide resin; a (meth)acrylate terminated polybutadiene or an acrylate or methacrylate capped silicone.

4. A composition as claimed in any of claims 1 to 3 characterized in that the composition comprises by weight;

50-60% of a (meth)acrylate urethane, a (meth)acrylated polyester urethane, a (meth)acrylated polyepoxide, a (meth)acrylated polybutadiene or mixtures thereof;

10-30% of a monofunctional ethylenically unsaturated diluent monomer;

0-3% of a monomer having plural (meth)acrylic functionality;

0.5-5% of a monomer selected from vinyl esters of saturated oil acids;

0-20% of a poly(alkylene oxide) (meth)acrylate having three or more alkoxy repeat units or a saturated $C_{10}$ or higher hydrocarbyl (meth)acrylate, and 0-10% of a silica thixotrope.

5. A composition as claimed in claim 4 wherein the monofunctional ethylenically unsaturated diluent monomer is N-vinyl pyrrolidone, N-vinyl carbazole, or isobornyl acrylate.

6. A composition as claimed in claim 4 or 5 characterized in that the vinyl ester of a saturated oil ester is vinyl stearate.

7. A composition as claimed in any of claims 4 to 6 characterized in that the composition includes 2-6% of a silica thixotrope.

8. A method for providing a temporary mask on a substrate, wherein a coating layer of a liquid radiation curable composition is applied to the areas of the substrate to be masked and the composition is irradiated with actinic light for sufficient time to cure the composition, wherein the composition is characterized by cured properties a) which provide adhesion to the substrate which is sufficient to prevent ingress of solder, plating or cleaning materials in subsequent soldering, plating or cleaning operations, but which is insufficient to resist hand peeling forces; and b) which provide sufficient cohesive strength to the coating layer to allow substantially all of the layer to be peeled off mechanically or by hand in a single piece.

9. A method as claimed in claim 8 wherein the substrate is a printed circuit board.

10. A method as claimed in claim 9 wherein the subsequent operation is a wave soldering operation, the method further comprising mechanically removing the mask after the wave soldering operation and inserting and hand soldering a thermally sensitive component to the areas of the board exposed when the mask was removed.

**Patentansprüche**

1. Zusammensetzung für eine zeitweilige Maske zur Verwendung bei Arbeitsgängen bei der Herstellung elektrischer oder elektronischer Teile, welche Zusammensetzung

(a) eine strahlungshärtbare Monomerformulierung, die eine vorherrschende Menge eines acryl-endverkappten Präpolymers einschließt, und

(b) einen Radikalphotoinitiator umfaßt, dadurch gekennzeichnet, daß die Zusammensetzung weiterhin

(c) eine aus polymeren Plastifizierern und Acrylestern von gesättigten Fettalkoholen, Vinylestern von gesättigten Fettsäuren, Monoacrylestern von Polyalkylenoxiden oder Mischungen davon ausgewählte die Haftung vermindernde Komponente in einer Menge umfaßt, die ausreicht, die Zugscherhaftung der Zusammensetzung, wenn auf dem elektronischen oder elektrischen Teil ausgehärtet, auf etwa 379,2 kPa (55 Psi) oder weniger zu vermindern, wobei die Zusammensetzung über ausreichende Kohäsionskraft verfügt, daß die ausgehärtete Zusammensetzung mechanisch oder von Hand in im wesentlichen einem Stück vom Substrat abgezogen werden kann.

2. Zusammensetzung nach Anspruch 1, dadurch gekennzeichnet, daß die Zusammensetzung eine Viskosität von wenigstens etwa 100 000 mPas (100 000 cps) aufweist.

3. Zusammensetzung nach Anspruch 1 oder 2, worin das acrylatendverkappte Polymer ein acryliertes oder methacryliertes Polyesterurethan, ein mit Acrylat oder Methacrylat verkapptes Polybutadienurethan, ein Acrylat- oder Methacrylatester, hergestellt durch Reaktion von (Meth)acrylsäure mit einem Polyepoxidharz, ein (meth)acrylat-terminiertes Polybutadien oder ein mit Acrylat oder Methacrylat verkapptes Silikon ist.

4. Zusammensetzung nach einem der Ansprüche 1 bis 3, dadurch gekennzeichnet, daß die Zusammensetzung sewichtsmäßig

50 bis 60 % (Meth)acrylaturethan, (meth)acryliertes Polyesterurethan, (meth)acryliertes Polyepoxid, (meth)acryliertes Polybutadien oder Mischungen davon;

10 bis 30 % eines monofunktionell ethylenisch ungesättigten verdünnenden Monomers;

0 bis 3 % eines Monomers mit mehrfach.er (Meth)acrylfunktionalität;

0,5 bis 5 % eines aus Vinylestern von gesättigten Ölsäuren ausgewählten Monomers;

0 bis 20 % Poly(alkylenoxid) (Meth)acrylat mit drei oder mehr Alkoxy-Wiederholungseinheiten oder gesättigtes $C_{10}$- oder höheres Kohlenwasserstoff(meth)acrylat sowie 0 bis 10 % eines Siliciumdioxid-Thixotropierers umfaßt.

5. Zusammensetzung nach Anspruch 4, worin das monofunktionelle ethylenisch ungesättigte verdünnende Monomer N-Vinylpyrrolidon, N-Vinylcarbazol oder Isobornylacrylat ist.

6. Zusammensetzung nach Anspruch 4 oder 5, dadurch gekennzeichnet, daß der Vinylester einer gesättigten Ölsäure Vinylstearat ist.

7. Zusammensetzung nach einem der Ansprüche 4 bis 6, dadurch gekennzeichnet, daß die Zusammensetzung 2 bis 6 % Siliciumdioxid-Thixotropes enthält.

8. Verfahren zur Erzeugung einer temporären Maske auf einem Substrat, worin eine Überzugsschicht einer flüssigen, durch Strahlung härtbaren Zusammensetzung auf die zu maskierenden Flächen des Substrats aufgebracht wird und die Zusammensetzung für eine zur Härtung der Zusammensetzung ausreichende Zeit mit aktinischem Licht bestrahlt wird, und worin die Zusammensetzung durch Eigenschaften nach der Aushärtung gekennzeichnet ist, die a) eine Haftung an das Substrat verleihen, die ausreicht, das Eindringen von Löt-, Plattierungs- oder Reinigungsmaterialien in anschließenden Löt-, Plattierungs- oder Reinigungsschritten zu verhindern, jedoch nicht ausreicht, den Kräften beim Abziehen mit der Hand zu widerstehen, und b) der Überzugsschicht hinreichende Kohäsionskraft zu verleihen, das im wesentlichen die ganze Schicht mechanisch oder mit der Hand in einem einzigen Stück abgezogen werden kann.

9. Verfahren nach- Anspruch 8, worin das Substrat eine bedruckte Leiterplatte ist.

10. Verfahren nach Anspruch 9, worin der anschließende Schritt ein Wellenlötschritt ist, wobei das Verfahren weiterhin die mechanische Entfernung der Maske nach dem Wellenlötschritt und das Einfügen und das Handverlöten einer thermisch empfindlichen Komponente an den nach der Entfernung der Maske freigelegten Flächen der Platte umfaßt.

## Revendications

1. Une composition pour masque temporaire à utiliser dans des opérations de fabrication de composants électriques et électroniques, la composition comprenant :

(a) une formulation de monomère durcissable par irradiation comprenant une quantité prédominante de prépolymère à coiffage acrylique terminal,

(b) un photo-initiateur engendrant des radicaux, caractérisée en ce que la composition contient également

(c) un composant réducteur d'adhérence choisi parmi les plastifiants polymères et les esters acryliques d'alcools gras saturés, les esters de vinyle d'acides gras saturés, les esters monoacryliques de poly(oxydes d'alkylène), et leurs mélanges, en une quantité suffisante pour réduire à environ 379,2 kPa (55 psi) ou moins l'adhérence au cisaillement par traction de la composition lorsqu'elle est durcie sur le composant électronique ou électrique, la composition ayant une force de cohésion suffisante pour que la composition durcie puisse être décollée mécaniquement ou manuellement du substrat sensiblement d'une seule pièce.

2. Une composition telle que revendiquée dans la revendication 1, caractérisée en ce que la composition a une viscosité d'au moins environ 100 000 mPa.s (100 000 cPo).

3. Une composition telle que revendiquée dans la revendication 1 ou 2, dans laquelle le prépolymère à coiffage acrylique terminal est un polyester-uréthanne à fonctionnalité acrylate ou méthacrylate ; un polybutadiène-uréthanne coiffé par une fonctionnalité acrylate ou méthacrylate ; un ester acrylique ou méthacrylique préparé par réaction d'acide (méth)acrylique avec une résine polyépoxyde ; un polybutadiène à fonctionnalité (méth)acrylate terminale ou une silicone coiffée par une fonctionnalité acrylate ou méthacrylate.

4. Une composition telle que revendiquée dans l'une quelconque des revendications 1 à 3, caractérisée en ce que la composition comprend, en poids :

50 à 60 % d'un uréthanne à fonctionnalité (méth)acrylate, d'un polyester-uréthanne à fonctionnalité (méth)acrylate, d'un polyépoxyde à fonctionnalité (méth)acrylate, d'un polybutadiène à fonctionnalité (méth)acrylate ou de mélanges d'entre eux ;

10 à 30 % d'un monomère diluant éthyléniquement insaturé monofonctionnel ;

0 à 3 % d'un monomère à fonctionnalité (méth)acrylique multiple ;

0,5 à 5 % d'un monomère choisi parmi les esters de vinyle d'acides gras saturés ;

0 à 20 % d'un (méth)acrylate de poly(oxyde d'alkylène) ayant trois ou plus de trois motifs alcoxy récurrents ou d'un (méth)acrylate d'hydrocarbyle en $C_{10}$ ou plus, et 0 à 10 % de silice comme agent de thixotropie.

5. Une composition telle que revendiquée dans la revendication 4, dans laquelle le monomère diluant éthyléniquement insaturé monofonctionnel est la N-vinylpyrrolidone, le N-vinylcarbazole ou l'acrylate d'isobornyle.

6. Une composition telle que revendiquée dans la revendication 4 ou 5, caractérisée en ce que l'ester de vinyle d'un acide gras saturé est le stéarate de vinyle.

7. Une composition telle que revendiquée dans l'une quelconque des revendications 4 à 6, caractérisée en ce que la composition comprend 2 à 6 % de silice comme agent de thixotropie.

8. Un procédé pour établir un masque temporaire sur un substrat, dans lequel une couche de revêtement d'une composition liquide durcissable par irradiation est appliquée sur les zones du substrat devant être masquées et la composition est irradiée par une lumière actinique pendant un temps suffisant pour durcir la composition, dans lequel la composition est caractérisée par des propriétés à l'état durci a) qui assurent une adhérence au substrat qui est suffisante pour empêcher l'introduction de soudure, de matières de dépôt ou de nettoyage au cours des opérations subséquentes de soudage, dépôt ou nettoyage, mais qui est insuffisante pour résister à des forces de pelage à la main ; et b) qui assurent une force de cohésion suffisante à la couche de revêtement pour que sensiblement toute la couche puisse être décollée d'une seule pièce mécaniquement ou à la main.

9. Un procédé tel que revendiqué dans la revendication 8, dans lequel le substrat est une plaquette de circuit imprimé.

10. Un procédé tel que revendiqué dans la revendication 9, dans lequel l'opération subséquente est une opération de soudage à la vague, le procédé consistant en outre à enlever mécaniquement le masque après l'opération de soudage à la vague et à insérer et souder à la main un composant sensible à la chaleur sur les zones de la plaquette mises à découvert lorsque le masque a été enlevé.

Fig.-1

Fig.-2

Fig.-3

Fig.-4

Fig.-5

13